# EUROPEAN PATENT APPLICATION

(11) **EP 2 493 275 A2**
(43) Date of publication of application: **29.08.2012**
(21) Application number: 11195557.1
(22) Date of filing: 23.12.2011
(51) Int. Cl.: H05K 5/02

(54) **Dew-condensation detecting apparatus, electronic equipment cooling system, and dew-condensation detecting method**

(30) Priority: 24.02.2011 JP 2011038920
(71) Applicant: Fujitsu Limited, Kawasaki-shi, Kanagawa 211-8588 (JP)
(72) Inventor: So, Tsuyoshi, Kawasaki-shi, Kanagawa 211-8588 (JP); Kubo, Hideo, Kawasaki-shi, Kanagawa 211-8588 (JP); Uzuka, Yoshinori, Kawasaki-shi, Kanagawa 211-8588 (JP); Maeda, Hideki, Kawasaki-shi, Kanagawa 211-8588 (JP)
(74) Representative: Tsang, Olivia

(57) **Abstract**

A dew-condensation detecting apparatus includes a dew-condensation detector provided in a middle of a cold-liquid supply passage. The cold-liquid supply passage supplies a cooling liquid to electronic equipment. The dew-condensation detector detects dew condensation by detecting water droplets due to the dew condensation. A heating part heats the cooling liquid which has exited from the dew-condensation detector.

## Description

The embodiment discussed herein is directed to a dew-condensation detecting apparatus for detecting dew-condensation by detecting water droplets generated by dew condensation.

When a temperature of a component of electronic equipment goes down to a temperature below a dew point of circumambient air, dew condensation occurs on a surface of the component of the electronic equipment. A water component generated by the dew condensation may cause corrosion of metal parts of the electronic equipment or cause short-circuiting between electrodes of an electric circuit inside the electronic equipment, which may cause a problem due to dew condensation.

Generally, temperature and humidity of an environment of liquid-cooled electronic equipments are managed so that dew condensation does not occur. However, if an air conditioner malfunctions or a temperature abnormality occurs in a cooling liquid output apparatus, a temperature of a cooling liquid, which reaches the electronic equipment, may be below a dew point, and, thereby, the interior of the electronic equipment may be set in a dew-condensation condition. It is possible that a power of the electronic equipment is turned on, or the electronic equipment continues to operate in such a dew-condensation condition. In such a case, if an amount of water droplets due to dew condensation exceeds a certain amount in the interior of the electronic equipment, short-circuiting between electrodes may occur in an electric circuit in the interior of the electronic equipment, which may cause an erroneous operation or burn-out of the electric circuit.

In order to prevent such a problem due to dew condensation, it is suggested to detect dew condensation by providing a dew-condensation sensor in an electronic equipment to take measures for dew condensation. That is, if dew condensation is detected by the dew-condensation sensor, the electronic equipment is prohibited from being turned on, or a dehydrating process is performed inside the electronic equipment.

There are some kinds of dew-condensation sensors. A dew-condensation water detecting sensor is known which detects dew condensation by detecting water droplets, which are generated due to dew condensation, flowing and reaching a detecting part. Such a dew-condensation sensor generally includes a measuring object formed by a metal, which tends to generate dew condensation, and a water-droplet sensor (a liquid sensor) to detect water droplets formed on the measuring object. The measuring object is provided in a cold-water supply passage between a cold-water supply apparatus and electronic equipment so that the measuring object is cooled by cold water supplied from the cold-water supply apparatus. Accordingly, if the temperature of the measuring object becomes below a dew point of an atmosphere, dew condensation occurs on the measuring object. That is, the cold water supplied from the cold-water supply apparatus cools the measuring object of the dew-condensation water detecting sensor, and, thereafter, the cold water is supplied to the electronic equipment and cools a heat-generating part inside the electronic equipment.

The heat capacity of the measuring object of the dew-condensation detecting sensor is small, and is not a heat-generating object. Thus, a temperature of the cold water entering the electronic equipment after cooling the measuring object hardly changes from a temperature of the cold water supplied from the cold water supply apparatus to the measuring object. Therefore, if dew condensation occurs on the measuring object, it is possible that dew condensation occurs also on the cold water passages inside the electronic equipment at almost the same time.

There is suggested a cooling apparatus, which, if dew condensation occurs on a heat exchanger, warms near an outlet of the heat exchanger to eliminate the dew condensation (for example, refer to Japanese Laid-Open Patent Application No. 10-9735). The cooling apparatus can eliminate dew condensation near the outlet of the heat exchanger but may not eliminate dew condensation inside the electronic equipment. Additionally, the cooling apparatus eliminates dew condensation by warming-up by a heater only after detecting dew condensation which has already occurred.

Because the dew-condensation water detecting sensor detects dew condensation by detecting water droplets generated by dew condensation as mentioned above, a certain time period must be passed from a time of initiation of dew condensation until an amount of water droplets generated by dew condensation reaches a detectable amount. It is possible that water droplets are generated due to dew condensation in the electronic equipment during the time period from a time of initiation of dew condensation in the dew-condensation water detecting sensor and inside the electronic equipment until the dew-condensation water detection sensor detects the dew condensation. The water droplets caused by the dew condensation may cause the above-mentioned problem in the electronic equipment.

There is provided, according to an embodiment of an aspect of the invention, a dew-condensation detecting apparatus including: a dew-condensation detector provided in a middle of a cold-liquid supply passage, which supplies a cooling liquid, to detect dew condensation by detecting water droplets due to the dew condensation; and a heating part that heats the cooling liquid which has exited from the dew-condensation detector.

There is provide, according to an embodiment of another aspect, an electronic equipment cooling system including: a liquid-cooled electronic equipment of which internal parts are cooled by a cooling liquid; a cooling-liquid supply apparatus producing the cooling liquid supplied to the liquid-cooled electronic equipment; a supply passage connecting the cooling-liquid supply apparatus and the liquid-cooled electronic equipment to supply the cooling liquid from the cooling-liquid supply apparatus to the liquid-cooled electronic equipment; a return passage connecting the liquid-cooled electronic equipment and the cooling-liquid supply apparatus to return the cooling liquid from the liquid-cooled electronic equipment to the cooling-liquid supply apparatus; a dew-condensation detector provided in a middle of the supply passage; and a heating part provided between the dew-condensation detector and the liquid-cooled electronic equipment to heat the cooling liquid entering the liquid-cooled electronic equipment.

There is provided, according to an embodiment of a further aspect, a dew-condensation detecting method including: heating cooling liquid after exiting a dew-condensation detector and before entering an electronic equipment; detecting dew-condensation by the dew-condensation detector and supplying a dew-condensation detection signal to the electronic equipment.

Accordingly, because the cooling water of a temperature higher than the temperature at the dew-condensation detector is supplied to the electronic equipment, dew-condensation occurs at the dew-condensation detector earlier than inside the electronic equipment. Thus, dew-condensation can be detected by the dew-condensation detector before dew condensation occurs in the electronic equipment, thereby preventing a problem due to dew condensation in the electronic equipment.

The advantages of the embodiment will be realized and attained by means of the elements and combinations particularly pointed out in the appended claims.

It is to be understood that both the foregoing general description and the following detailed description are exemplary explanatory only and are not restrictive of the invention, as claimed.

Embodiments of the present invention will now be described, by way of example only, with reference to the accompanying drawings, in which:
FIG. 1 is an outline diagram illustrating an entire electronic equipment cooling system including a dew-condensation detecting apparatus according to a first embodiment;
FIG. 2 is a flowchart of a dew-condensation detecting process;
FIG. 3 is an outline diagram illustrating an entire electronic equipment cooling system including a dew-condensation detecting apparatus according to a second embodiment;
FIG. 4 is a perspective view of electronic equipment attached with an exhaust cooling apparatus; and
FIG. 5 is an outline diagram illustrating an entire electronic equipment cooling system including a dew-condensation detecting apparatus according to a third embodiment.

Embodiments of the present invention will be explained with reference to the accompanying drawings.

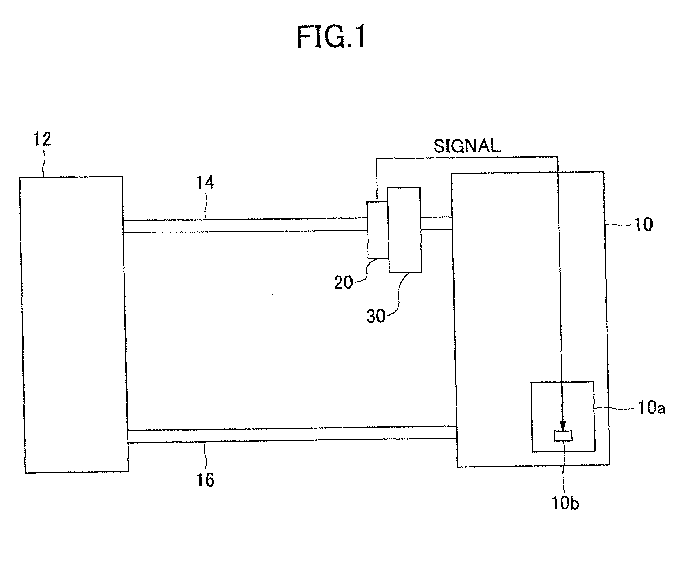

FIG. 1 is an outline diagram illustrating an entire electronic equipment cooling system including a dew-condensation detecting apparatus according to a first embodiment.

In FIG. 1, electronic equipment 10 is, for example, a liquid-cooled electronic equipment such as, for example, a computer or a server. Heat-generating parts (for example, a semiconductor device or a power supply circuit) inside the electronic equipment 10 are cooled by cooling water, which is an example of cooling-liquid, of a low temperature (hereinafter, referred to as cold water) supplied by a cold-water supply apparatus 12. The cold water produced by the cold-water supply apparatus 12 is supplied to a cooling water passage (not illustrated in the figure) in the electronic equipment through a cold-water supply pipe passage 14. The heat generating parts are arranged in the middle of the cooling water passage. The cold water flowing through the cooling water passage absorbs heat from the heat-generating parts to cool the heat-generating parts. The cooling water warmed by cooling the heat-generating parts (hereinafter, referred to as warm water) is returned from the cooling water passage inside the electronic equipment 10 to the cold-water supply apparatus 12 through the warm-water return pipe passage 16.

Although the cold-water supply apparatus 12 is a known cooling-water cooling apparatus having, for example, a refrigerator and a heat exchanger, a cooling-water cooling apparatus having any structure may be used if it is an apparatus capable of producing cold water by cooling warm water discharged from the electronic equipment 10 and supplying the warm water to the electronic equipment 10. Generally, a plurality of electronic equipments 10 are provided to one cold-water supply apparatus 12.

A dew-condensation sensor 20, which is an example of a dew-condensation detector, is provided in the middle of the cold-water supply pipe passage 14 provided between the cold-water supply apparatus 12 and the electronic equipment 10. If the cold-water supply pipe passage 14 is short, the dew-condensation sensor 20 may be provided at an arbitrary position along the cold-water supply pipe passage 14. If the cold-water supply pipe passage 14 is long, it is desirable to arrange the dew-condensation sensor 20 at a position close to the electronic equipment 10. This is because, if an environment (temperature and humidity) around the dew-condensation sensor 20 is equivalent to an environment (temperature and humidity) inside or around the electronic equipment 10, it can be regarded that dew-condensation detection performed by the dew-condensation sensor 20 is equivalent to dew-detection performed inside the electronic equipment 10.

The dew-condensation sensor 20 detects water droplets generated by dew condensation on the measuring object, and outputs a dew-condensation detection signal. The dew-condensation detection signal output by the dew-condensation sensor 20 is supplied to a service processor 10b provided in a control part 10a of the electronic equipment 10. The service processor 10b is a CPU, which performs a control to cause some functions of the electronic equipment 10 to be performed even when a main power of the electronic equipment 10 is turned off and a main function is deactivated. For example, if a dew-condensation detection signal is supplied, the service processor 10b can turn off the main power supply of the electronic equipment 10 to stop an operation of the electronic equipment 10.

A heater 30, which is an example of a heating part, is provided between the dew-condensation sensor 20 and the electronic equipment 10. The heater 30 is provided to raise the temperature of cold-water entering the electronic equipment 10 by heating the cold water, which has passed through the dew-condensation sensor 20. For example, if a temperature of cold water passing through the dew-condensation sensor 20 is 21°C, the cold water of 21°C is heated by the heater 30 at, for example, 23°C so that the cold-water of 23°C enters the electronic equipment 10.

For example, it is assumed that an environment in a server room where the electronic equipment 10 is installed is maintained with a room temperature of 25°C and a relative humidity of 50% or less, and the temperature of the cold-water supplied from the cold-water supply apparatus 12 is 21°C. In such an environment in the server room, it can be found by acquiring from the psychrometric chart that the dew point temperature at the dew-point sensor 20 and inside the electronic equipment 10 is 13.9°C. Accordingly, in this environment, there is no dew-condensation occurs because the temperature is below the dew-point temperature (13.9°C) at the dew-condensation sensor 20 (of which temperature is 21°C, which is the same as the cold water) and also at the cooling water passage (of which temperature is 23°C, which is the same as the cold water heated by the heater 30) inside the electronic equipment 10.

Here, it is assumed that the environment in the server room has changed due to, for example, a failure in an air-conditioning machine, and the room temperature is raised to 28°C and the relative humidity is raised to 70%. At this time, the dew-condensation temperature in the environment in the server room is raised to 22°C, which is higher than the temperature 21°C of the cold water. Accordingly, dew-condensation occurs at the dew-condensation sensor 20 of which temperature is 21°C, which is the same as the cold water. On the other hand, the cooling water passage in the electronic equipment 10 is at 23°C, which is the same temperature as the cold water heated by the heater 30.

If the environment in the server room continues to change and the room temperature or the relative humidity raises, the dew point temperature rises further from 22°C. Then, if the dew point temperature exceeds the temperature of 23°C of the cold water heated by the heater 30, dew condensation occurs also inside the electronic equipment 10.

However, it takes a certain time from a time at which the dew point temperature reaches 21°C of the dew-condensation sensor 20 until a time at which the dew point temperature reaches 23°C of the cooling water passage in the electronic equipment 10. During that time period, the dew-condensation at the dew-condensation sensor 20 progresses and the droplets are grown, which results in an amount of droplets becoming detectable by the dew-condensation sensor 20. That is, no dew-condensation is initiated in the electronic equipment 10 and, thus, no water droplets are produced during the time period from a time at which dew condensation is initiated at the dew-condensation sensor 20 due to a change in the environment in the server room until a time at which the dew-condensation sensor 20 outputs the dew-condensation detection signal.

Therefore, a problem in the electronic equipment 10 due to dew-condensation can be prevented from occurring by taking measures such as turning a power of the electronic equipment 10 off upon reception of the dew-condensation detection signal output from the dew-condensation sensor 20.

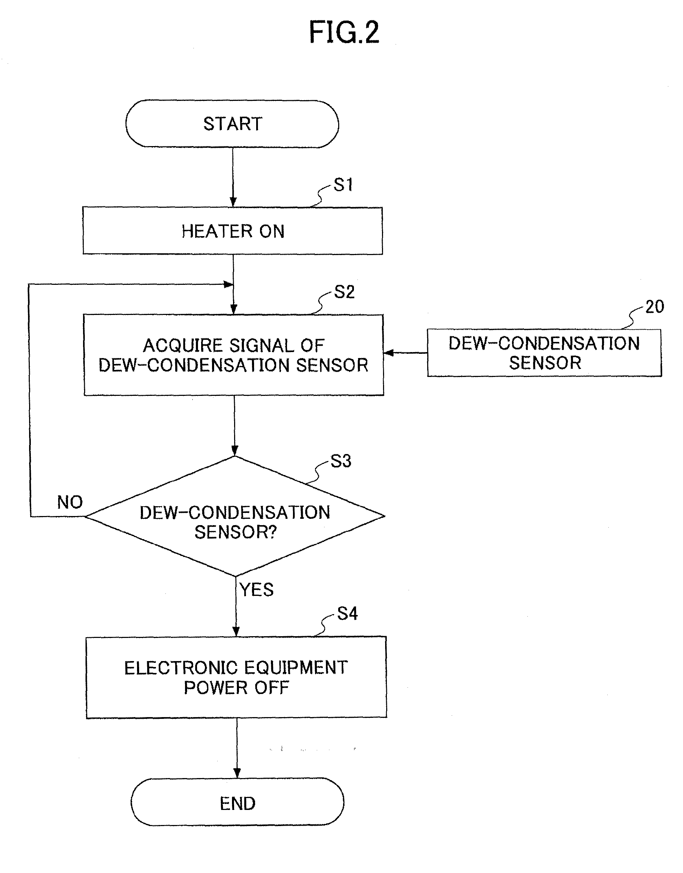

A description will now be given, with reference to FIG. 2, of a dew-condensation detecting method performed in the electronic equipment cooling system. FIG. 2 is a flowchart of a dew-condensation detecting process.

When the dew-condensation detecting process is started, first, the heater 30 is turned ON to perform heating of the cold water by the heater 30 (step S1). The time of turning ON the heater 30 may be a time of turning ON a power of the electronic equipment 10 or a time of starting supply of cold water to the electronic equipment 10. When supplying cold water to the electronic equipment 10, it is desirable to always turn ON the heater 30.

Then, the service processor 10b of the control part 10a of the electronic equipment 10 acquires a signal from the dew-condensation sensor 20 when the electronic equipment 10 is in operation and heat-generating parts inside the electronic equipment 10 are being cooled (step S2). Subsequently, the service processor 10b of the electronic equipment 10 determines whether the signal from the dew-condensation sensor 20 is a dew-condensation detection signal which indicates that dew condensation is detected (step S3). If it is determined in step S3 that the signal from the dew-condensation sensor 20 is not the dew-condensation detection signal, the process returns to step S2 and the service processor 10b acquires a signal from the dew-condensation sensor 20 again.

On the other hand, if it is determined in step S3 that the signal from the dew-condensation sensor 20 is the dew-condensation detection signal, the process proceeds to step S4. In step S4, the service processor 10b performs a process of interrupting (turning OFF) the power of the electronic equipment 10. At this time, a notification of the fact that a dew-condensation condition is established may be sent to a manager by using a display device or issuing a warning. Or, instead of turning OFF the power of the electronic equipment 10, a process of dehydrating the interior of the electronic equipment 10 may be performed to eliminate the dew condensation.

While the above-mentioned dew-condensation detecting process is performed, the cold water after passing through the dew-condensation sensor 20 and before entering the electronic equipment 10 is heated by the heater 30 so that the cold water is set to a temperature higher than the temperature at the dew-condensation sensor 20. Accordingly, during the time after the initiation of the dew condensation at the dew-condensation sensor 20 until the dew condensation is detected by the dew-condensation sensor 20, no dew condensation occurs inside the electronic equipment 10. Thus, measures for dew-condensation can be taken such that, for example, the power of he electronic equipment 10 is turned OFF, thereby preventing a problem due to dew condensation inside the electronic equipment 10.

Although the dew-condensation sensor 20 and the heater 30 are arranged outside and near the electronic equipment 10 in FIG. 2, if a sufficient space can be reserved inside the electronic equipment 10, the dew-condensation sensor 20 and the heater 30 may be provided inside the electronic equipment 10.

Moreover, although the heater 30 is attached to the dew-condensation sensor 20 in FIG. 2, it is desirable to provide a heat insulator between the heater 30 and the dew-condensation sensor 20 so that the heat of the heater 30 is not transmitted to the dew-condensation sensor 20. Alternatively, the heater 30 may be arranged at a position remote from the dew-condensation sensor 20. The heater 30 may be arranged at an arbitrary position if it can raise the temperature of the cold water after exiting from the dew-condensation sensor 20 and before entering the electronic equipment 10. The dew-condensation sensor 20 and the heater 30 together constitute the dew-condensation detecting apparatus.

As for the heater 30, a heater performing heating by electric energy, such as an electric heater (resistance heating heater) or an induction heater, may be used. Instead of using the heater 30, the cold water may be heated by exhaust heat from the electronic equipment 10. Moreover, instead of using the heater 30, the cold water may be heated using heat from heat-generating parts of peripheral equipments of the electronic equipment 10.

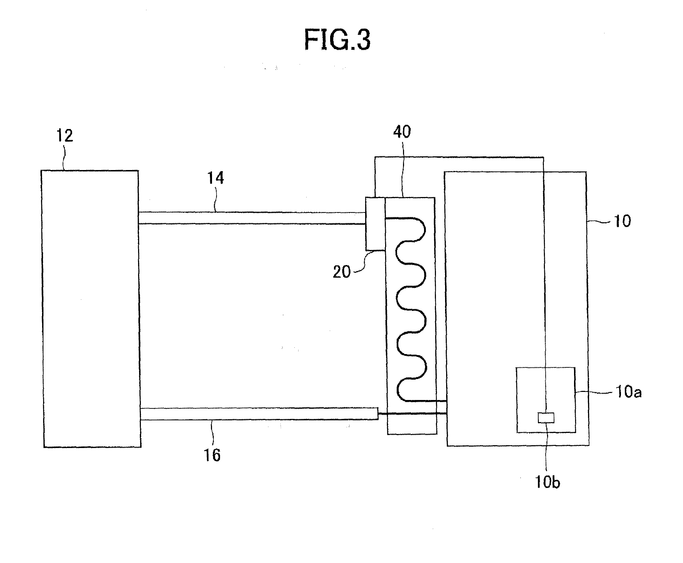

A description will be given below of a second embodiment. FIG. 3 is an outline diagram of an entire electronic equipment cooling system including a dew-condensation detecting apparatus according to the second embodiment. In FIG. 3, parts that are the same as the parts illustrated in FIG. 1 are given the same reference numerals, and descriptions thereof will be omitted.

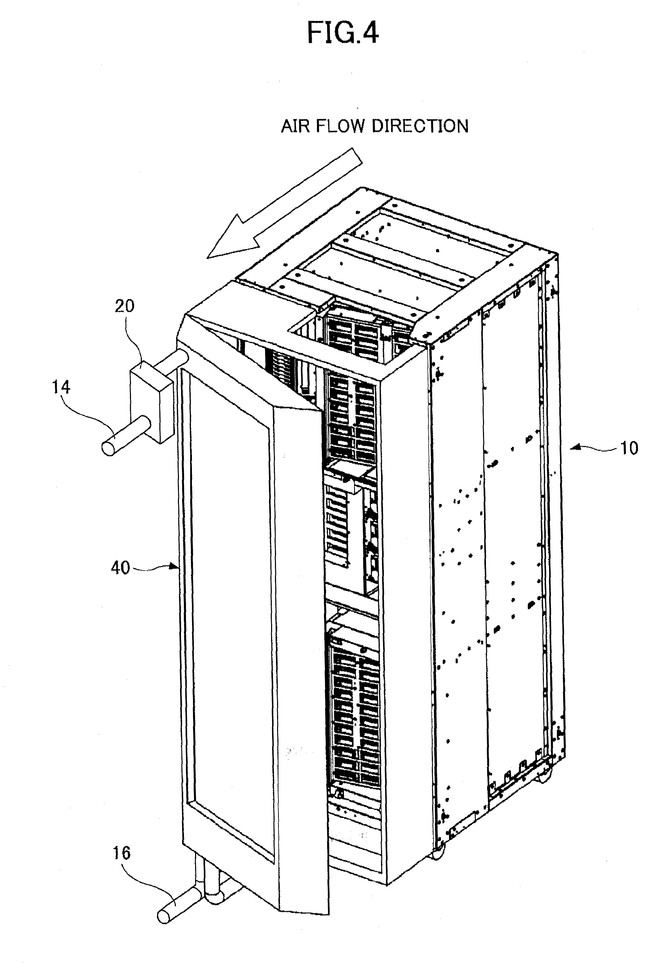

In the electronic equipment cooling system illustrated in FIG. 3, an exhaust cooling apparatus 40 is used as a heating part for heating cold water. That is, instead of heating cold water by the heater 30, the exhaust cooling apparatus 40 is used to heat the cold water. FIG. 4 is a perspective view of the electronic equipment 10 attached with the exhaust cooling apparatus 40.

In many cases, the electronic equipment 10 is provided with an air-cooling mechanism besides a mechanism to cool the heat-generating parts inside the electronic equipment 10 as mentioned above. The air-cooling mechanism cools the internal parts of the electronic equipment 10 using air taken into the electronic equipment 10. As for the air-cooling mechanism, an air blower such as a fan may be used to take air outside the electronic equipment 10 and ventilate the interior of the electronic equipment 10. The warmed air after cooling the interior of the electronic equipment 10 is exhaust outside the electronic equipment 10.

The exhaust cooling apparatus 40 is a heat exchanger for cooling the air exhausted outside from the electronic equipment 10. For example, the exhaust cooling apparatus 40 cools air exhausted from the electronic equipment 10 by causing the air exhausted from the electronic equipment 10 to pass therethrough while flowing cooling water supplied from an external part. In the present embodiment, the cold water passed through the dew-condensation sensor 20 is used as the cooling water to be supplied to the exhaust cooling apparatus 40.

That is, the cold-water supply pipe passage 14 extending from the dew-condensation sensor 20 is connected to the cooling-water passage of the exhaust cooling apparatus 40. The cold water, which exited from the dew-condensation sensor 20, flows through the cooling water passage of the exhaust cooling apparatus 40 and cools the air exhausted from the electronic equipment 10, and, thereby, the cold water absorbs heat of the exhaust air and a temperature thereof is raised. Accordingly, similar to heating by the heater 30, the cold water can be heated by the exhaust cooling apparatus 40 and a temperature of the cold water can be raised.

Although FIG. 4 illustrates, for the purpose of illustration, a state where the interior of the electronic equipment 10 is exposed by removing the exhaust cooling apparatus 40 from the electronic equipment 10, the exhaust cooling apparatus 40 actually covers the exhaust surface of the electronic equipment 10.

According to the present embodiment, an effect of energy saving can also be obtained because the cold water is heated by using exhaust heat from the electronic equipment 10.

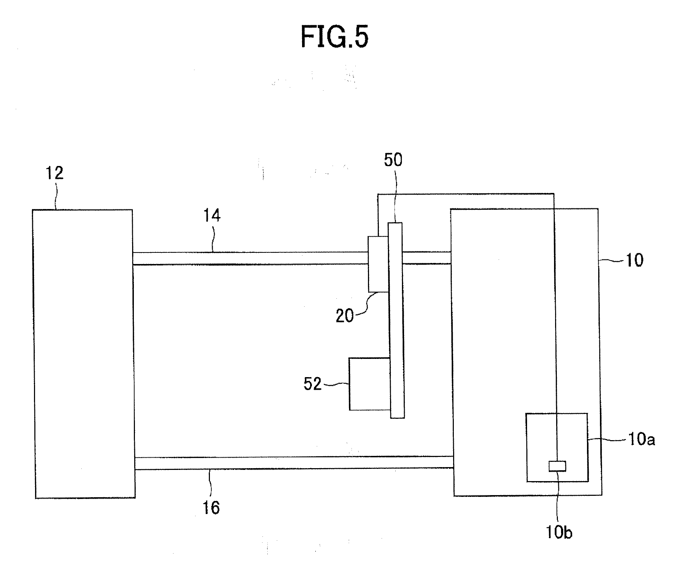

A description will be given below of a third embodiment. FIG. 5 is an outline diagram of an entire electronic equipment cooling system including a dew-condensation detecting apparatus according to the third embodiment. In FIG. 5, parts that are the same as the parts illustrated in FIG. 1 are given the same reference numerals, and descriptions thereof will be omitted.

In the electronic equipment cooling system illustrated in FIG. 5, a heat transfer member 50 is used as a heating part for heating the cold water. That is, instead of the heater 30 to heat the cold water, the heat transfer member 50 to which a heat generator 52 is attached is used to heat the cold water.

The heat transfer member 50 is formed of a material such as, for example, a metal plate having a large thermal conductivity. Alternatively, a heat pipe may be use as the heat transfer member 50. The heat transfer member 50 is attached with the heat generator 52 as a heat source. By using a heat generating part such as peripheral equipments or peripheral parts of the electronic equipment 10 as the heat generator 52, an effect of exhaust heat recovery can be obtained. However, for example, an exclusive heater may be used as the heat generator 52.

## Claims

1. A dew-condensation detecting apparatus comprising:
a dew-condensation detector, provided on a cold-liquid supply passage, configured to supply a cooling liquid, to detect dew condensation by detecting water droplets due to the dew condensation; and
a heating part configured to heat the cooling liquid which has exited from said dew-condensation detector.

2. The dew-condensation detecting apparatus as claimed in claim 1, wherein said heating part includes an electric heater.

3. The dew-condensation detecting apparatus as claimed in claim 1, wherein said heating part includes an exhaust cooling apparatus.

4. The dew-condensation detecting apparatus as claimed in claim 1, wherein said heating part includes a heat transfer member and a heat generator provided to the heat transfer member.

5. An electronic equipment cooling system comprising:
a liquid-cooled electronic equipment, the internal parts of which are cooled by a cooling liquid;
a cooling-liquid supply apparatus configured to produce the cooling liquid supplied to said liquid-cooled electronic equipment;
a supply passage arranged to connect said cooling-liquid supply apparatus and said liquid-cooled electronic equipment to supply the cooling liquid from said cooling-liquid supply apparatus to said liquid-cooled electronic equipment;
a return passage arranged to connect said liquid-cooled electronic equipment and said cooling-liquid supply apparatus to return the cooling liquid from said liquid-cooled electronic equipment to said cooling-liquid supply apparatus;
a dew-condensation detector provided on said supply passage; and
a heating part provided between said dew-condensation detector and said liquid-cooled electronic equipment configured to heat the cooling liquid entering said liquid-cooled electronic equipment.

6. The electronic equipment cooling system as claimed in claim 5, wherein said heating part includes an electric heater provided to said supply passage.

7. The electronic equipment cooling system as claimed in claim 5, wherein said heating part includes an exhaust cooling apparatus that cools an exhaust of said liquid-cooled electronic equipment.

8. The electronic equipment cooling system as claimed in claim 5, wherein said heating part includes a heat transfer member provided to said supply passage and a heat generator provided to the heat transfer member.

9. The electronic equipment cooling system as claimed in claim 8, wherein said heat generator includes peripheral equipments or peripheral parts of said liquid-cooled electronic equipment.

10. A dew-condensation detecting method comprising:
heating cooling liquid after exiting a dew-condensation detector and before entering an electronic equipment;
detecting dew-condensation by said dew-condensation detector and supplying a dew-condensation detection signal to said electronic equipment.

11. The dew-condensation detecting method as claimed in claim 10, further comprising turning off a power of said electronic equipment based on said dew-condensation detection signal.
